# EUROPEAN PATENT APPLICATION

(11) **EP 4 749 310 A1**
(43) Date of publication of application: **27.05.2026**
(21) Application number: 24863119.4
(22) Date of filing: 29.08.2024
(51) Int. Cl.: G01R 31/396, G01R 31/382, G01R 31/385, G01R 19/165, H02J 7/00, B60L 58/10

(54) **BATTERY IDENTIFICATION DEVICE AND OPERATING METHOD THEREFOR**

(30) Priority: 04.09.2023 KR 20230117244
(71) Applicant: LG Energy Solution, Ltd., Seoul 07335 (KR)
(72) Inventor: LEE, Ko Woon, Daejeon 34122 (KR)
(74) Representative: Plasseraud IP
(86) International application number: PCT/KR2024/012932
(87) International publication number: WO 2025/053538

(57) **Abstract**

A battery identification apparatus according to an embodiment disclosed herein includes a communication circuit configured to obtain charging data including a voltage value and a capacity of one or more batteries, and a processor configured to extract, from the charging data, reference charging data in which the capacity corresponds to a reference capacity condition and identify the battery based on the reference charging data and a battery manufacturer identification condition.

## Description

### TECHNICAL FIELD

### CROSS-REFERENCE TO RELATED APPLICATION

This application claims priority to and the benefit of Korean Patent Application No. 10-2023-0117244 filed in the Korean Intellectual Property Office on September 4, 2023, the entire content of which is incorporated herein by reference.

### TECHNICAL FIELD

Embodiments disclosed herein relate to a battery identification apparatus and an operating method thereof.

### BACKGROUND ART

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

There may be several manufacturers producing secondary batteries. Depending on manufacturers, materials or manufacturing method used to manufacture batteries may differ, which may lead to differences in battery performance. As a battery pack included in an electric vehicle may include battery cells manufactured by a plurality of manufacturers, it is necessary to accurately determine a state or a degradation level of the battery pack even when the battery cells manufactured by the plurality of manufacturers are used together.

### DISCLOSURE

### TECHNICAL PROBLEM

Typically, to determine a manufacturer of a battery, it is necessary to check a serial number of the battery. However, when battery cells manufactured by a plurality of manufacturers are in a battery pack mounted on an electric vehicle, it is realistically difficult to check the serial number of each battery cell.

Technical problems of the embodiments disclosed herein are not limited to the above-described technical problems, and other unmentioned technical problems would be clearly understood by one of ordinary skill in the art from the following description.

### TECHNICAL SOLUTION

A battery identification apparatus according to an embodiment disclosed herein includes a communication circuit configured to obtain charging data including a voltage value and a capacity of one or more batteries, and a processor configured to extract, from the charging data, reference charging data in which the capacity corresponds to a reference capacity condition and identify the battery based on the reference charging data and a battery manufacturer identification condition.

In an embodiment, the capacity may be a state of charge (SOC) of the battery, and the reference capacity condition may be a condition that the SOC corresponds to a reference SOC.

In an embodiment, the processor may be further configured to identify the battery based on whether a charge end voltage value that is a voltage value corresponding to the reference SOC included in the reference charging data is greater than or equal to a threshold value.

In an embodiment, the capacity may be a depth of discharge (DOD) of the battery, and the reference capacity condition may be a condition that the DOD corresponds to a reference DOD.

In an embodiment, the charging data may include data regarding a change of the DOD with respect to the voltage value in a charging process of the battery, and the processor may be further configured to generate voltage value-dQ/dV data based on the reference charging data and
identify the battery based on the voltage-dQ/dV data and the battery manufacturer identification condition.

In an embodiment, the processor may be further configured to identify the battery based on whether there is a dQ/dV peak value in a voltage range designated based on the voltage value-dQ/dV data.

In an embodiment, the charging data may include the voltage value and the capacity, measured in a slow charging process of the battery.

An operating method of a battery identification apparatus, according to an embodiment disclosed herein includes obtaining charging data including a voltage value and a capacity of one or more batteries, extracting, from the charging data, reference charging data in which the capacity corresponds to a reference capacity condition, and identifying the battery based on the reference charging data and a battery manufacturer identification condition.

In an embodiment, the capacity may be a state of charge (SOC) of the battery, and the reference capacity condition may be a condition that the SOC corresponds to a reference SOC.

In an embodiment, the identifying may include identifying the battery based on whether a charge end voltage value that is a voltage value corresponding to the reference SOC included in the reference charging data is greater than or equal to a threshold value.

In an embodiment, the capacity may be a depth of discharge (DOD) of the battery, and the reference capacity condition may be a condition that the DOD corresponds to a reference DOD.

In an embodiment, the charging data may include data regarding a change of the DOD with respect to the voltage value in a charging process of the battery, and the identifying may include generating voltage value-dQ/dV data based on the reference charging data and identifying the battery based on the voltage-dQ/dV data and the battery manufacturer identification condition.

In an embodiment, the identifying may include identifying the battery based on whether there is a dQ/dV peak value in a voltage range designated based on the voltage value-dQ/dV data.

In an embodiment, the charging data may be data obtained in a slow charging process of the battery.

### ADVANTAGEOUS EFFECTS

A battery identification apparatus and an operating method thereof according to various embodiments disclosed herein may identify a manufacturer of a battery by using charging data including a voltage value and a capacity of the battery.

Therefore, the battery identification apparatus and the operating method thereof may reduce a time and a cost for identifying the manufacturer of the battery.

The technical effects of the battery identification apparatus and the operating method thereof according to embodiments disclosed in the present document are not limited to the effects mentioned above, and other effects not mentioned will be clearly understood by those of ordinary skill in the art according to the disclosure of the present document.

### DESCRIPTION OF DRAWINGS

FIG. 1 illustrates a battery identification system according to an embodiment disclosed herein.
FIG. 2 is a block diagram of a battery identification apparatus according to an embodiment disclosed herein.
FIG. 3 is a graph of temperature-charge end voltage values according to an embodiment disclosed herein.
FIG. 4 is a graph of voltage values-dQ/dV values according to an embodiment disclosed herein.
FIGS. 5 to 7 are flowcharts showing an operating method of a battery identification apparatus according to an embodiment disclosed herein.

With regard to the description of the drawings, identical reference numerals may be used to refer to identical or related elements.

### MODE FOR INVENTION

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. In the case of online distribution, at least a part of a computer program product may be at least temporarily stored in a machine-readable storage medium such as a memory of a server of a manufacturer, a server of an application store, or a relay server, or may be generated temporarily.

According to embodiments disclosed herein, each of the above-described components (e.g., a module or program) may include a single entity or a plurality of entities, some of which may be separately disposed on other components. According to embodiments disclosed herein, one or more of the above-described components or operations may be omitted, or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to embodiments disclosed herein, operations performed by a module, a program, or other components may be executed sequentially, in parallel, repeatedly, or heuristically, or one or more of the operations may be executed in a different order or omitted, or one or more other operations may be added.

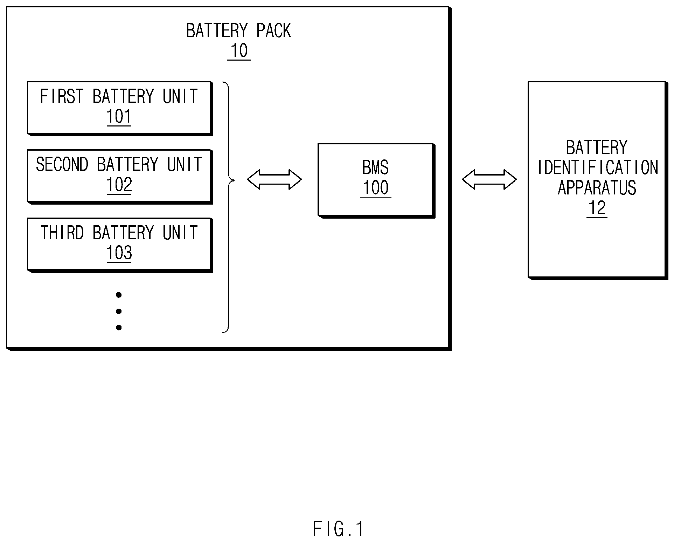

FIG. 1 illustrates a battery identification system according to an embodiment disclosed herein.

Referring to FIG. 1, a battery identification system may include a battery pack 10 and a battery identification apparatus 12.

The battery pack 10 may include a plurality of battery units 101, 102, and 103 and a battery management system (BMS) 100. Herein, each of the battery units 101, 102, and 103 may be a battery cell or a battery module. The following description will be made assuming that each of the battery units 101, 102, and 103 is a battery module included in the battery pack 10 and the battery module includes a plurality of battery cells.

The BMS 100 may obtain values related to a state of a battery cell or a battery module included in the battery pack 10. The BMS 100 may monitor, control, and manage the battery pack 10 to maintain an optimal state of the battery cell or the battery module included in the battery pack 10 based on the state-related values of the battery cell or the battery module. Herein, the state-related values may include one or more values of voltage, current, resistance, state of charge (SOC), state of health (SOH) of the battery cell or the battery module or a combination thereof. Hereinbelow, the value related to the state may be referred to as a 'state value'.

The battery pack 10 may be included in an electronic device. The electronic device may be a mobile device (e.g., a mobile phone, a laptop computer, a smart phone, a smart pad), an electric vehicle (e.g., an electric vehicle (EV), a hybrid EV (HEV), a plug-in HEV (PHEV), a fuel cell EV (FCEV)), an energy storage system (ESS), or a battery swapping system (BSS).

Hereinbelow, the battery pack 10, the battery module, or the battery cell will be collectively referred to as a battery. That is, the battery mentioned below may mean the battery cell, the battery module, or the battery pack 10.

The battery identification apparatus 12 may obtain charging data including one or more voltage values and capacities. Herein, the capacity of the battery may mean an SOC or a depth of discharge (DOD) of the battery. The charging data may include a voltage value and a capacity of the battery, measured in a charging process of the battery.

The battery identification apparatus 12 may extract, from the charging data, reference charging data in which a capacity corresponds to a reference capacity condition. Herein, the reference capacity condition may be a condition that the SOC of the battery corresponds to a reference SOC or a condition that the DOD of the battery corresponds to a reference DOD. For example, the reference charging data corresponding to the condition that the SOC of the battery corresponds to the reference SOC may be charging data until the SOC of the battery reaches 96.5 % in a charging process of the battery from among a plurality of charging data. The reference charging data corresponding to the condition that the DOD of the battery corresponds to the reference DOD may be charging data measured in the charging process of the battery, starting from a state where the DOD of the battery is at least 85 %, from among the plurality of charging data.

The battery identification apparatus 12 may identify the battery based on the reference charging data and a battery manufacturer identification condition. The battery identification apparatus 12 may identify the manufacturer of the battery based on the reference charging data and a battery manufacturer identification condition. Herein, the battery manufacturer identification condition may mean a condition observed only in a battery manufactured by a specific battery manufacturer, and may be an indicator for identifying the manufacturer of the battery. The battery manufacturer identification condition may include a charge end voltage value of the battery. Herein, the charge end voltage value may be a voltage value when the SOC of the battery is the reference SOC in the charging process of the battery. For example, when first battery cells manufactured by a first manufacturer have a charge end voltage value being greater than or equal to about 4.18 V and second battery cells manufactured by a second manufacturer have a charge end voltage value less than about 4.178 V, the charge end voltage value may be included in a battery manufacturer identification condition.

While one battery pack 10 is shown in the battery identification system, this is merely for convenience of a description, and the battery identification system may include a plurality of battery packs and the battery identification apparatus 12 may simultaneously/separately identify a manufacturer of each of a plurality of battery packs.

While the foregoing description has been made assuming that operations of the battery identification apparatus 12 are performed outside the battery pack 10 such as a server, a cloud, a charger, a charger/discharger, etc., the operations of the battery identification apparatus 12 may also be performed by the BMS 100.

In an embodiment, when the operations of the battery identification apparatus 12 are performed in the server, the cloud, the charger, the charger/discharger, etc., connection between the battery identification apparatus 12 and the electronic device including the battery pack 10 may be communication connection made through a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a 4th-Generation (4G) network, a 5th-Generation (5G) network). In an embodiment, the connection between the battery identification apparatus 12 and the electronic device may be connection using a device-to-device communication scheme (e.g., a bus, a general-purpose input and output (GPIO), a serial peripheral interface (SPI), or a mobile industry processor interface (MIPI)).

The battery identification apparatus 12 may be wiredly and/or wirelessly connected to the user terminal 30. Herein, the user terminal 30 may be a mobile device (e.g., a mobile phone, a laptop computer, a smart phone, a smart pad), or a personal computer (PC). The battery identification apparatus 12 may transmit and receive data to and from the user terminal 30 through a wired and/wireless communication channel. The battery identification apparatus 12 may transmit a result of identifying the manufacturer of the battery to the user terminal 30.

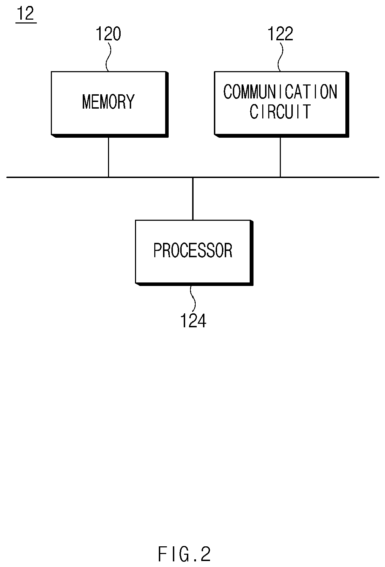

FIG. 2 is a block diagram of a battery identification apparatus according to an embodiment disclosed herein.

Referring to FIG. 2, the battery identification apparatus 12 may include a memory 120, a communication circuit 122, and a processor 124. According to an embodiment, the battery identification apparatus 12 shown in FIG. 2 may further include at least one component (e.g., a display, a sensor, an input device, or an output device) in addition to components shown in FIG. 2. In an embodiment, when the operations performed in the battery identification apparatus 12 are performed in the BMS 100, the battery identification apparatus 12 may further include a sensor for measuring a state value of the battery.

The memory 120 may include a volatile and/or a nonvolatile memory. In an embodiment, the memory 120 may include one or more software. In an embodiment, the memory 120 may store data used by at least one component (e.g., the processor 124) of the battery identification apparatus 12. For example, the data may include software (or an instruction related thereto), input data, or output data. In an embodiment, the instruction, when executed by the processor 124, may cause the battery identification apparatus 12 to perform operations defined by the instruction.

The communication circuit 122 may establish a wired communication channel and/or a wireless communication channel between the battery identification apparatus 12 and the electronic device including the battery pack 10, and transmit and receive data to and from the electronic device through the established communication channel.

The communication circuit 122 may obtain charging data through the wired and/or wireless communication channel. The communication circuit 122 may obtain the charging data of the battery, obtained by the BMS 100, through the wired and/or wireless communication channel. Herein, the charging data may include a voltage value and a capacity of the battery. According to embodiments, the charging data may further include a temperature of the battery.

The processor 124 may extract, from the charging data, reference charging data in which the capacity of the battery corresponds to the reference capacity condition. Herein, the reference charging data may include values corresponding to the battery manufacturer identification condition to identify the manufacturer of the battery. For example, the reference charging data may be charging data including the voltage value and the SOC of the battery, measured until the SOC of the battery reaches the reference SOC, from among the charging data.

In an embodiment, the processor 214 may extract, from the charging data, the reference charging data in which the SOC of the battery corresponds to the reference SOC. The processor 124 may extract, from the charging data, the reference charging data obtained in a slow charging process until the SOC of the battery reaches the reference SOC. For example, the processor 124 may extract, from the charging data, the reference charging data including values measured in the slow charging process until the SOC of the battery reaches 96.5 %. Herein, slow charge may be a scheme to charge the battery using alternating current (AC) electricity and may include a case where charging current is charged with about 15 to 17 A.

In an embodiment, the processor 214 may extract, from the charging data, the reference charging data in which the DOD of the battery corresponds to the reference DOD. Herein, the charging data may include data regarding a change of the DOD with respect to the voltage value measured in the charging process of the battery. The processor 124 may extract, from the charging data, the reference charging data including values measured in a slow charging process of the battery, starting from a state in which the DOD of the battery is greater than or equal to the reference DOD. For example, the processor 124 may extract, from the charging data obtained in the slow charging process of the battery, the reference charging data for the battery charged slowly in a state where the DOD is at least 85 %.

The processor 124 may identify the battery based on the reference charging data and a battery manufacturer identification condition. The processor 124 may identify the manufacturer of the battery based on the reference charging data and the battery manufacturer identification condition. Herein, the battery manufacturer identification condition may include a charge end voltage value of the battery for each battery manufacturer and a dQ/dV variance with respect to a voltage value.

In an embodiment, the processor 124 may identify the battery based on the charge end voltage value that is a voltage value obtained when the SOC of the battery is the reference SOC. The processor 124 may identify the manufacturer of the battery based on whether the charge end voltage value is greater than or equal to a threshold value.

In an embodiment, the communication circuit 122 may obtain charging data further including the temperature of the battery. The processor 124 may generate temperature-charge end voltage value data based on the reference charging data further including the temperature. The processor 124 may generate a temperature-charge end voltage value graph based on the charge end voltage value and the temperature of the battery, included in the reference charging data. The processor 124 may identify the battery based on whether the charge end voltage value is greater than or equal to a threshold value in a temperature or temperature range designated based on the temperature-charge end voltage value data. For example, the processor 124 may identify a battery having a charge end voltage value at a designated temperature being greater than or equal to the threshold value as a battery manufactured by the first manufacturer and a battery having a charge end voltage value at the designated temperature being less than the threshold value as a battery manufactured by the second manufacturer. A reason to further consider a relationship between the charge end voltage value and the temperature is that the charge end voltage value may differ with the temperature of the battery. Thus, the processor 124 may more accurately identify the manufacturer of the battery by identifying the battery based on the charge end voltage value at the designated temperature or in the designated temperature range.

In an embodiment, the processor 124 may identify the battery based on the charge end voltage value that is a voltage value obtained when the SOC of the battery is the reference SOC. The processor 124 may identify the manufacturer of the battery based on whether the charge end voltage value is greater than or equal to a threshold value.

In an embodiment, the processor 124 may generate voltage value-dQ/dV data based on the reference charging data in which the DOD of the battery corresponds to the reference DOD. The processor 124 may generate a voltage value-dQ/dV graph based on the voltage value of the battery, included in the reference charging data. The processor 124 may identify the battery based on whether there is a dQ/dV peak value in the voltage range or voltage value designated based on voltage value-dQ/dV data. For example, the processor 124 may identify a battery having a dQ/dV peak value in the designated voltage range or the designated voltage value as the battery manufactured by the first manufacturer and a battery not having a dQ/dV peak value in the designated voltage range or the designated voltage value as the battery manufactured by the second manufacturer.

In an embodiment, the processor 124 may include a central processing unit, an application processor, a graphic processing unit, a neural processing unit (NPU), an image signal processor, a sensor hub processor, or a communication processor.

In an embodiment, the processor 124 may execute software to control at least one other component (e.g., a hardware or software component) of the battery identification apparatus 12 connected to the processor 124 and may process or compute various data.

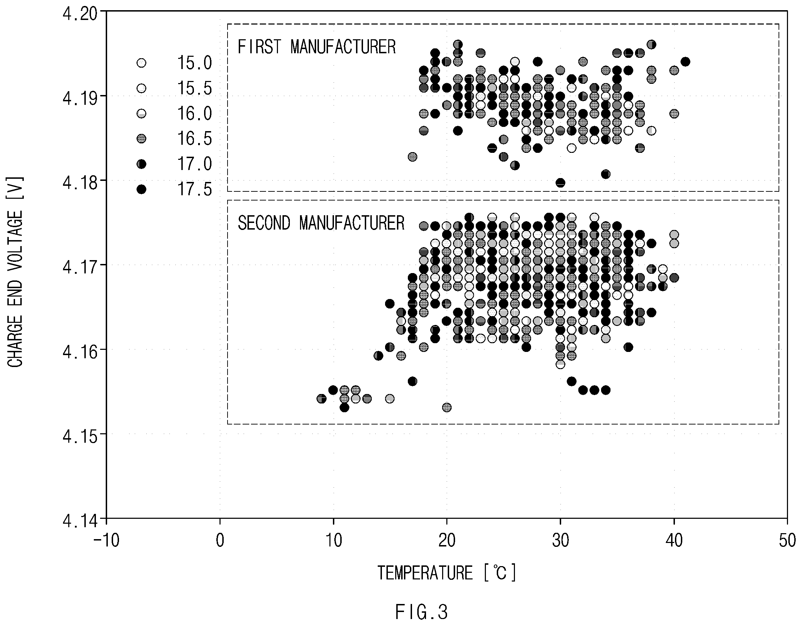

FIG. 3 is a graph of temperature-charge end voltage values according to an embodiment disclosed herein.

Referring to FIG. 3, the graph may include a charge end voltage value with respect to a temperature of the battery.

Referring to the graph, based on a charge end voltage value of about 4.178 V, the battery manufactured by the first manufacturer and the battery manufactured by the second manufacturer may be distinguished from each other. A reason the charge end voltage value differs with the battery manufacturer is because a battery charging protocol may differ from manufacturer to manufacturer even for batteries having the same capacity.

The processor 124 may generate a temperature-charge end voltage value graph based on the reference charging data. The processor 124 may identify the manufacturer of the battery based on whether the charge end voltage value is greater than or equal to a threshold value at a temperature or in a temperature range, designated based on the temperature-charge end voltage value graph. For example, the processor 124 may identify a battery having a charge end voltage value of about 4.178 V or higher at 20 degrees Celsius as a battery cell manufactured by the first manufacturer. The processor 124 may identify a battery having a charge end voltage value less than about 4.178 V at 20 degrees Celsius as a battery cell manufactured by the second manufacturer.

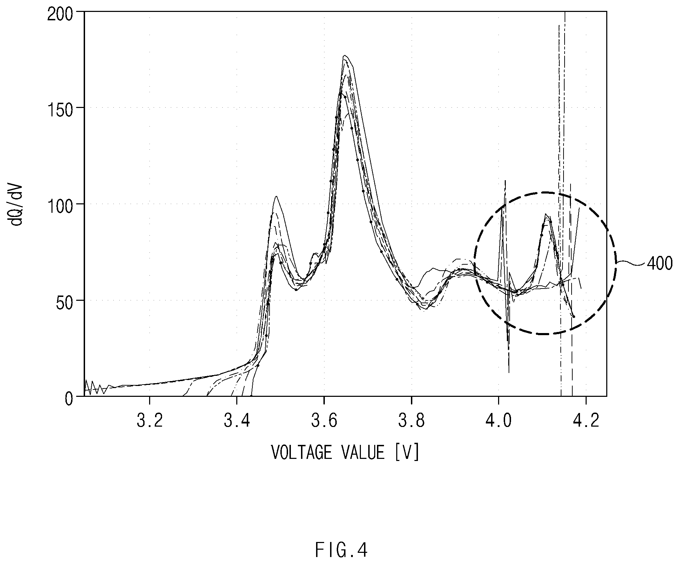

FIG. 4 is a graph of voltage values-dQ/dV values according to an embodiment disclosed herein.

Referring to FIG. 4, the graph may include a dQ/dV value with respect to a voltage value of the battery.

Referring to the graph, it may be seen that there is a battery cell having a dQ/dV value being a peak value in a designated voltage range 400. For example, referring to the graph, when the designated voltage range 400 is between 4 V and 4.2 V, there is a battery cell having a dQ/dV peak value in a dQ/dV range between about 50 and 100. A reason whether the dQ/dV peak value exists in the specified voltage range or specified voltage value differs with a battery manufacturer is because even battery cells having the same capacity may have different active material compositions of positive electrodes for different manufacturers. For example, a battery manufactured using an NCM 811 material may have a dQ/dV peak value at about 4.1 V due to the characteristics of the NCM 811 material. Thus, the battery identification apparatus 12 may distinguish the battery manufactured using the NCM 811 material from among a plurality of batteries through the voltage value-dQ/dV graph.

The processor 124 may generate a voltage value-dQ/dV graph based on the reference charging data. The processor 124 may identify the manufacturer of the battery based on whether a dQ/dV value corresponds to a peak value in the voltage range or voltage value designated based on the voltage value-dQ/dV graph. For example, the processor 124 may identify a battery having a dQ/dV value being a peak value between 4.1 V and 4.2 V as the battery manufactured by the first manufacturer. The processor 124 may identify the battery having the dQ/dV value not being the peak value at 4.1 V as the battery manufactured by the second manufacturer.

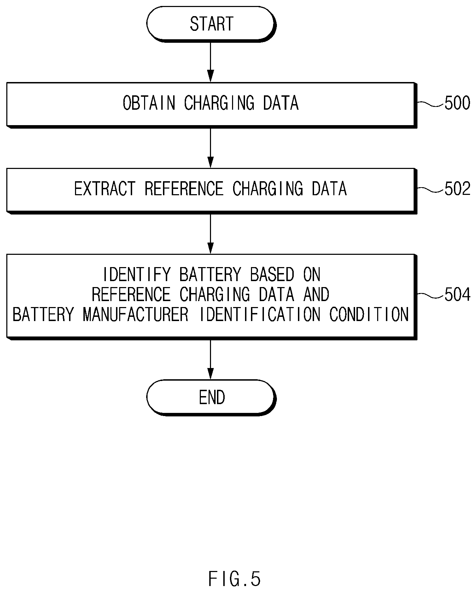

FIG. 5 is a flowchart showing an operating method of a battery identification apparatus according to an embodiment disclosed herein.

Referring to FIG. 5, in operation 500, the battery identification apparatus 12 may obtain charging data including voltage values and capacities of one or more batteries.

In operation 502, the battery identification apparatus 12 may extract reference charging data from the charging data. The battery identification apparatus 12 may extract, from the charging data, reference charging data in which a capacity corresponds to a reference capacity condition.

In operation 504, the battery identification apparatus 12 may identify the battery based on the reference charging data and a battery manufacturer identification condition. The battery identification apparatus 12 may identify the manufacturer of the battery based on the reference charging data and a battery manufacturer identification condition.

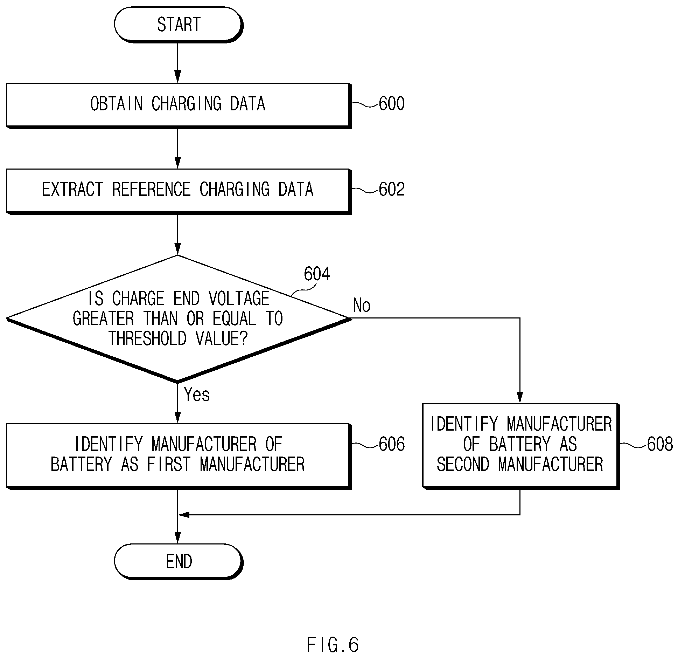

FIG. 6 is a flowchart showing an operating method of a battery identification apparatus according to an embodiment disclosed herein.

Referring to FIG. 6, in operation 600, the battery identification apparatus 12 may obtain charging data including voltage values and capacities of one or more batteries.

In operation 602, the battery identification apparatus 12 may extract, from the charging data, the reference charging data in which the SOC of the battery corresponds to the reference SOC. The battery identification apparatus 12 may extract, from the charging data, the reference charging data obtained in a charging process until the SOC of the battery reaches the reference SOC.

In operation 604, the battery identification apparatus 12 may identify the manufacturer of the battery based on the reference charging data in which the SOC of the battery corresponds to the reference SOC. The battery identification apparatus 12 may identify the manufacturer of the battery based on the charge end voltage value that is a voltage value when the SOC of the battery is the reference SOC. The battery identification apparatus 12 may identify the manufacturer of the battery based on whether the charge end voltage value is greater than or equal to a threshold value.

In an embodiment, the battery identification apparatus 12 may obtain charging data further including the temperature of the battery. The battery identification apparatus 12 may generate temperature-charge end voltage value data based on a temperature and a charge end voltage value. The battery identification apparatus 12 may generate a temperature-charge end voltage graph based on the charge end voltage value and the temperature of the battery, included in the reference charging data.

In operation 606, the battery identification apparatus 12 may identify a battery having a charge end voltage value greater than or equal to a threshold value as the battery manufactured by the first manufacturer.

In an embodiment, the battery identification apparatus 12 may identify, as the battery manufactured by the first manufacturer, a battery having the charge end voltage being greater than or equal to a threshold value at a temperature or in a temperature range, designated based on the temperature-charge end voltage value data.

In operation 608, the battery identification apparatus 12 may identify a battery having a charge end voltage value less than the threshold value as the battery manufactured by the second manufacturer.

In an embodiment, the battery identification apparatus 12 may identify, as the battery manufactured by the second manufacturer, a battery having the charge end voltage being less than the threshold value at the temperature or in the temperature range designated based on the temperature-charge end voltage value data.

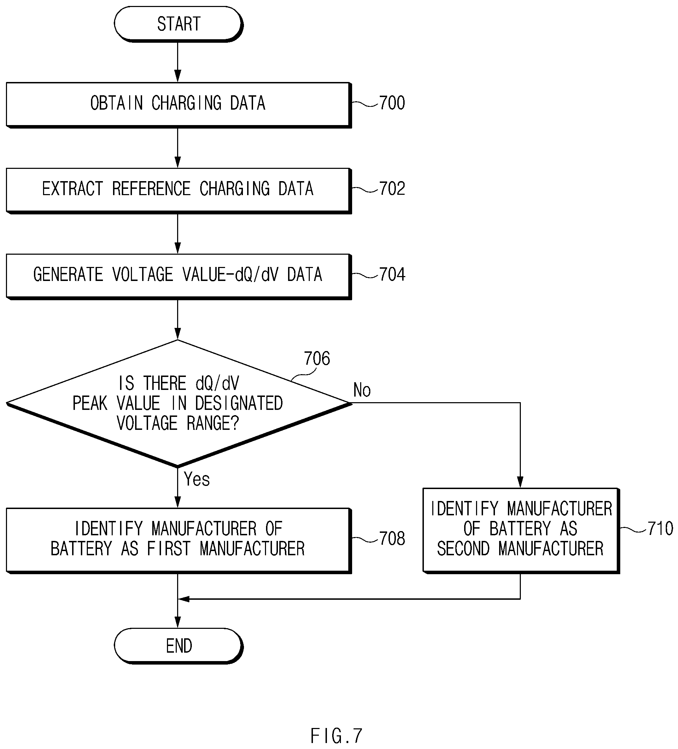

FIG. 7 is a flowchart showing an operating method of a battery identification apparatus according to an embodiment disclosed herein.

Referring to FIG. 7, in operation 700, the battery identification apparatus 12 may obtain charging data including at least one of voltage values and capacities of one or more batteries.

In operation 702, the battery identification apparatus 12 may extract, from the charging data, the reference charging data in which the DOD of the battery corresponds to the reference DOD. The battery identification apparatus 12 may extract, from the charging data, the reference charging data obtained in the charging process in a state where the DOD of the battery is greater than or equal to the reference DOD.

In operation 704, the battery identification apparatus 12 may generate voltage value-dQ/dV data based on reference charging data obtained in the charging process in a state where the DOD of the battery is greater than or equal to the reference DOD. The battery identification apparatus 12 may generate a voltage value-dQ/dV graph based on the voltage value of the battery, included in the reference charging data.

In operation 706, the battery identification apparatus 12 may determine whether there is a dQ/dV peak value corresponding to a voltage value designated based on the voltage value-dQ/dV data.

In operation 708, the battery identification apparatus 12 may identify, as the battery manufactured by the first manufacturer, a battery having a dQ/dV value being a peak value corresponding to a voltage range or a voltage value designated based on the voltage value-dQ/dV data.

In operation 710, the battery identification apparatus 12 may identify, as the battery manufactured by the second manufacturer, a battery having a dQ/dV value not being the peak value corresponding to the voltage range or the voltage value designated based on the voltage value-dQ/dV data.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

## Claims

1. A battery identification apparatus comprising:
a communication circuit configured to obtain charging data comprising a voltage value and a capacity of one or more batteries; and
a processor configured to:
extract, from the charging data, reference charging data in which the capacity corresponds to a reference capacity condition; and
identify the battery based on the reference charging data and a battery manufacturer identification condition.

2. The battery identification apparatus of claim 1, wherein the capacity is a state of charge (SOC) of the battery, and
the reference capacity condition is a condition that the SOC corresponds to a reference SOC.

3. The battery identification apparatus of claim 2, wherein the processor is further configured to identify the battery based on whether a charge end voltage value that is a voltage value corresponding to the reference SOC included in the reference charging data is greater than or equal to a threshold value.

4. The battery identification apparatus of claim 1, wherein the capacity is a depth of discharge (DOD) of the battery, and
the reference capacity condition is a condition that the DOD corresponds to a reference DOD.

5. The battery identification apparatus of claim 4, wherein the charging data comprises data regarding a change of the DOD with respect to the voltage value in a charging process of the battery, and
the processor is further configured to:
generate voltage value-dQ/dV data based on the reference charging data; and
identify the battery based on the voltage value-dQ/dV data and the battery manufacturer identification condition.

6. The battery identification apparatus of claim 5, wherein the processor is further configured to identify the battery based on whether there is a dQ/dV peak value in a voltage range designated based on the voltage value-dQ/dV data.

7. The battery identification apparatus of claim 1, wherein the charging data comprises the voltage value and the capacity, measured in a slow charging process of the battery.

8. An operating method of a battery identification apparatus, comprising:
obtaining charging data comprising a voltage value and a capacity of one or more batteries;
extracting, from the charging data, reference charging data in which the capacity corresponds to a reference capacity condition; and
identifying the battery based on the reference charging data and a battery manufacturer identification condition.

9. The operating method of claim 8, wherein the capacity is a state of charge (SOC) of the battery, and
the reference capacity condition is a condition that the SOC corresponds to a reference SOC.

10. The operating method of claim 9, wherein the identifying comprises identifying the battery based on whether a charge end voltage value that is a voltage value corresponding to the reference SOC included in the reference charging data is greater than or equal to a threshold value.

11. The operating method of claim 8, wherein the capacity is a depth of discharge (DOD) of the battery, and
the reference capacity condition is a condition that the DOD corresponds to a reference DOD.

12. The operating method of claim 11, wherein the charging data comprises data regarding a change of the DOD with respect to the voltage value in a charging process of the battery, and
the identifying comprises:
generating voltage value-dQ/dV data based on the reference charging data; and
identifying the battery based on the voltage value-dQ/dV data and the battery manufacturer identification condition.

13. The operating method of claim 12, wherein the identifying comprises identifying the battery based on whether there is a dQ/dV peak value in a voltage range designated based on the voltage value-dQ/dV data.

14. The operating method of claim 8, wherein the charging data is data obtained in a slow charging process of the battery.
